# EUROPEAN PATENT APPLICATION

(11) **EP 1 826 803 A2**
(43) Date of publication of application: **29.08.2007**
(21) Application number: 06256319.2
(22) Date of filing: 12.12.2006
(51) Int. Cl.: H01J 17/49

(54) **Plasma display device**

(30) Priority: 12.12.2005 KR 20050121868; 13.11.2006 KR 20060111917
(71) Applicant: LG Electronics Inc., Yongdungpo-gu Seoul (KR)
(72) Inventor: Kim, Hong Tak 107-1803 Soosung Bosung Town, Taegu-si 706-034 (KR); Bae, Kwang Bae 102-201 Daewoo Apt.Jinpyung, Gumi-si 730-755 (KR); Kwon, Hyung Seok 106-701 Hyundai Apt, Inchun-si 405-234 (KR)
(74) Representative: Palmer, Jonathan R.

(57) **Abstract**

The present invention relates to a plasma display device. A reduction layer is directly formed on a front substrate of a panel. Accordingly, the manufacturing cost of the plasma display device can be saved, phenomena, such as Moire and double image, can be improved, a bright and dark room contrast ratio can be improved, and a sharper picture quality can be provided. Further, the reduction layer includes a conductive material. Accordingly, there are advantages in that EMI and NIR can be shielded, and an erroneous operation occurring when the plasma display device is driven can be prevented.

## Description

BACKGROUND

### 1. Field of the Invention

The present invention relates to a plasma display device and, more particularly, to a plasma display device in which a reduction layer having at least one of an Electromagnetic Interference (EMI)-shielding function, an Near Infrared (NIR)-shielding function and a black matrix function is directly formed on a front surface of a panel, thus saving the manufacturing cost and improving the sharpness of the panel.

### 2. Discussion of Related Art

In general, a plasma display panel is an apparatus in which discharge is generated when voltage is applied to electrodes arranged in discharge spaces and phosphors are excited with plasma generated at the time of gas discharge, thus displaying images including texts and/or graphics. The plasma display panel is advantageous in that it can be made large-sized, light, flat and slim, can provide a wide viewing angle in all directions, and can implement full colors and high luminance.

A film filter or a glass filter is attached to the front surface of the plasma display panel in order to accomplish an EMI-shielding function, a function of reducing the reflection of external light, and an NIR-shielding function.

If the film filter or the glass filter is attached to the front surface of the panel as described above, there are problems in that a unit cost of the panel increases due to the use of an expensive filter, and efficiency is low since the filter is spaced apart from the front surface of the panel at a predetermined distance.

### SUMMARY OF THE INVENTION

Accordingly, the present invention has been made to solve the problems of the background art.

A plasma display device according to an embodiment of the present invention includes a front substrate, and a rear substrate opposite to the front substrate and having a plurality of barrier ribs for physically dividing discharge cells formed therein, the plasma display device comprising a first electrode and a second electrode formed on a first surface of the front substrate, and a reduction layer directly formed on a second surface of the front substrate.

The reduction layer preferably comprises at least one layer formed from a conductive material. The conductive material may include at least one of ITO (Indium-Tin-Oxide), IZO (Indium-Zinc-Oxide), IZTO (Indium-Zinc-Tin-Oxide) and silver (Ag).

Further, the reduction layer may be formed from a metal material of a lattice form. The reduction layer may include a black layer directly formed on the second surface, or two or more layers including the black layer.

The reduction layer may have a thickness of 10 to 250 nm or a thickness of 10 to 200 nm.

The reduction layer may have sheet resistance of 4 Ω/m² or less and transmittance of 35 % or more.

Furthermore, a film filter closely adhered to the reduction layer may be formed over the reduction layer, or a glass filter spaced apart from the reduction layer at a specific distance may be formed over the reduction layer. One of a film filter and a glass filter formed over the reduction layer may include at least one of an anti-reflection layer for decreasing reflection of external light, a color control layer for color adjustment and color correction, and an adhesive layer.

A plasma display device according to another embodiment of the present invention includes a front substrate, and a rear substrate opposite to the front substrate and having a plurality of barrier ribs for physically dividing discharge cells formed therein, the plasma display device comprising a first electrode and a second electrode formed on a first surface of the front substrate, a first reduction layer directly formed on a second surface of the front substrate and formed from a conductive material, and a second reduction layer directly formed on the first reduction layer and formed from a black material.

The black material is preferably overlapped with the barrier ribs. The conductive material may include at least one of ITO, IZO, IZTO and silver (Ag).

Furthermore, the second reduction layer may be formed in a lattice or stripe form. The second reduction layer may comprise a conductive material.

In this case, the conductive material may comprise at least one of copper (Cu), silver (Ag), aluminum (Al), Zinc (Zn) and chrome (Cr).

A film filter closely adhered to the second reduction layer may be formed over the second reduction layer, or a glass filter spaced apart from the second reduction layer at a specific distance may be formed over the second reduction layer.

A method of manufacturing a plasma display device according to still another embodiment of the present invention includes the steps of forming a scan electrode and a sustain electrode on a first surface of a substrate, directly coating a conductive material on a second surface of the substrate, and sintering the conductive material directly coated on the second surface of the substrate.

The step of directly coating the conductive material on the second surface may be performed by using any one of a spin method, a sputtering method, a spray method, and an electron beam method.

The method may further include the steps of directly printing a black material the second surface, or the conductive material coated on the second surface, and drying the black material.

### BRIEF DESCRIPTION OF THE DRAWINGS

FIG. 1 is a view illustrating a first embodiment of the construction of a plasma display panel according to the present invention;
FIG. 2 is a perspective view illustrating a first embodiment of a reduction layer of the plasma display panel according to the present invention;
FIG. 3 is a perspective view illustrating a second embodiment of a reduction layer of the plasma display panel according to the present invention;
FIG. 4 is a perspective view illustrating a third embodiment of a reduction layer of the plasma display panel according to the present invention;
FIG. 5 is a view illustrating a second embodiment of the construction of a plasma display panel according to the present invention;
FIG. 6 is a perspective view illustrating a fourth embodiment of a reduction layer of the plasma display panel according to the present invention;
FIG. 7 is a flowchart illustrating an embodiment of a method of manufacturing a plasma display device according to the present invention;
FIG. 8 is a view illustrating the arrangement of electrodes of the plasma display panel;
FIG. 9 is a view illustrating an embodiment of a method in which one frame of an image of the plasma display panel is driven with it being time-divided into a plurality of subfields; and
FIG. 10 shows a waveform illustrating an embodiment of driving signals for driving the plasma display panel with respect to divided subfields.

### DETAILED DESCRIPTION OF THE INVENTION

A plasma display device according to he present invention will now be described in detail in connection with specific embodiments with reference to the accompanying drawings.

It is, however, to be noted that the plasma display device according to the present invention is not limited to the following embodiments, but may be implemented in various ways.

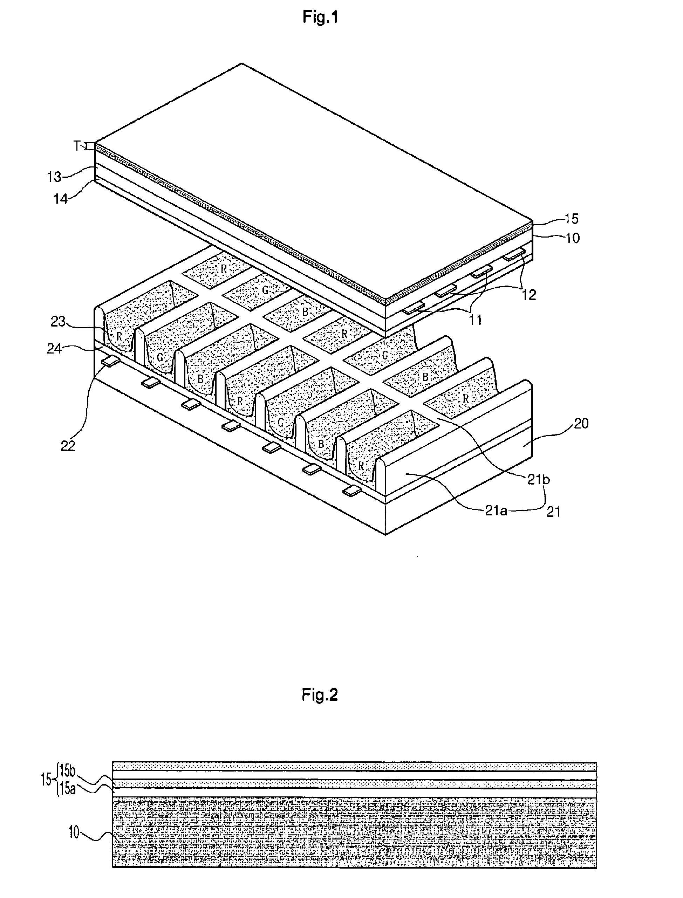

FIG. 1 is a view illustrating a first embodiment of the construction of a plasma display panel according to the present invention.

Referring to FIG. 1, a plasma display panel according to an embodiment of the present invention includes a front substrate 10 in which scan electrodes 11 and sustain electrodes 12, which are parallel to each other, are formed, and a rear substrate 20 in which address electrodes 22 crossing the scan electrodes 11 and the sustain electrodes 12 are formed. The front substrate 10 and the rear substrate 20 are coalesced together.

Each of the scan electrode 11 and the sustain electrode 12 includes a transparent electrode generally formed from Indium-Tin-Oxide (ITO), and a bus electrode that can be formed from metal, such as silver (Ag) or chrome (Cr), a stack of Cr/Cu/Cr, or a stack of Cr/Al/Cr. The bus electrode is formed on the transparent electrode, and functions to decrease voltage drop caused by the transparent electrode having high resistance.

Meanwhile, in the plasma display panel of the present invention, each of the scan electrode 11 and the sustain electrode 12 can have not only a structure in which the transparent electrode and the bus electrode are stacked, but also a structure having only the bus electrode without the transparent electrode. This structure is advantageous in that it can save the manufacture cost of the panel since the transparent electrode is not used. The bus electrode used in this structure can be formed from a variety of materials, such as a photoresist material, other than the above listed materials.

A black matrix (BM) can be formed between the transparent electrode and the bus electrode of the scan electrode 11 and the sustain electrode 12. The black matrix has a light-shielding function of absorbing external light occurring outside the front substrate 10 and thus reducing the reflection of the light, and a function of improving the purity and contrast of the front substrate 10.

The black matrix can have a first black matrix formed at a location overlapped with a barrier rib 21, and a second black matrix formed between the bus electrodes. The first black matrix and the second black matrix, which is also referred to as a "black layer" or "black electrode layer", can be formed at the same time in the formation process and can be thus physically connected, or cannot be formed at the same time in the formation process and cannot be thus physically connected.

In the case where the first black matrix and the second black matrix are physically connected, they can be formed using the same material. However, in the case where the first black matrix and the second black matrix are physically separated from each other, they can be formed using different materials.

An upper dielectric layer 13 and a protection layer 14 are laminated on the front substrate 10 in which the scan electrodes 11 and the sustain electrodes 12 are formed. Charged particles from which plasma is generated are accumulated on the upper dielectric layer 13.

The protection layer 14 functions to protect the upper dielectric layer 13 from the sputtering of charged particles, which is generated at the time of gas discharge, and increase emission efficiency of secondary electrons. The protection layer 14 can be formed by means of a method of depositing material, such as MgO, on the upper dielectric layer 13.

Meanwhile, the address electrodes 22 are formed in the rear substrate 20. A lower dielectric layer 24 to cover the address electrodes 22 is formed on a top surface of the rear substrate 20 in which the address electrodes 22 are formed. The lower dielectric layer 24 can serve to insulate the address electrodes 22.

The barrier ribs 21 are formed over the rear substrate 20. Phosphors 23 are coated between the barrier ribs 21.

Each barrier rib 21 includes a longitudinal barrier rib 21a parallel to the address electrode 22, and a traverse barrier rib 21b crossing the address electrode 22. The barrier rib 21 physically divides discharge cells, and can prevent ultraviolet rays, which are generated by discharge, and a visible ay from leaking to neighboring discharge cells.

The plasma display panel of the present invention can have not only the structure of the barrier ribs 21 as illustrated in FIG. 1, but also the structure of the barrier ribs 21 having a variety of shapes. For example, the plasma display panel of the present invention can have a differential type barrier rib structure in which the longitudinal barrier rib 21a and the traverse barrier rib 21b have different heights, a channel type barrier rib structure in which a channel that, which can be used as an exhaust passage, is formed in at least one of the longitudinal barrier rib 21a and the traverse barrier rib 21b, a hollow type barrier rib structure in which a hollow is formed in at least one of the longitudinal barrier rib 21a and the traverse barrier rib 21b, and so on.

In the differential type barrier rib structure, it is preferred that the traverse barrier rib 21b have a height higher than that of the longitudinal barrier rib 21a. The longitudinal barrier rib 21a can have a height higher than that of the traverse barrier rib 21b. In the channel type barrier rib structure or the hollow type barrier rib structure, it may be preferred that a channel or a hollow be formed in the traverse barrier rib 21b.

Meanwhile, in an embodiment of the present embodiment, it has been illustrated and described that the red (R), green (G) and blue (B) discharge cells are arranged on the same line. However, the R, G, and B discharge cells can be arranged on different lines. For example, the R, G, and B discharge cells can be arranged in a delta form in which the discharge cells are arranged in a triangle fashion, or can be arranged in a variety of forms, such as square, pentagon and hexagon.

The pitch of each discharge cell can be set differently depending on a color emitted from each of the discharge cells. In this case, it is preferred that the pitch of a discharge cell that emits the color (R) be the same as or smaller than that of a discharge cell that emits the color (G), and the pitch of a discharge cell that emits the color (B) be the same as or smaller than that of a discharge cell that emits the color (G) and that of a discharge cell that emits the color (R).

White (W) and/or yellow (Y) discharge cells may be further formed in addition to the R, G and B discharge cells.

A reduction layer 15 made of a conductive material is directly formed on a surface opposite to the front surface of the plasma display panel constructed above, that is, the surface in which the scan electrodes 11 and the sustain electrodes 12 are formed. The reduction layer 15 directly formed on the front surface of the front substrate 10 as described above can serve as an EMI-shielding function, an NIR-shielding function, a function of preventing the reflection of external light, and so on. A film filter or a glass filter can be further formed on the reduction layer 15. The film filter is formed on the front panel by means of a laminating method, and the glass filter is spaced apart from the plasma display panel at a predetermined distance.

A thickness T of the reduction layer 15 can be set in the range of 10 to 250 nm in consideration of the efficiency of the function due to electrical characteristics and the transmittance of light. In this case, transmittance through which light emitted from the panel can be smoothly transmitted can be secured, and adequate EMI-shielding efficiency can be accomplished through adequate conductivity. It is more preferable that the thickness of the reduction layer 15 be set in the range of 10 to 200 nm considering the electrical characteristics of the reduction layer 15 such that light can be smoothly transmitted and the protection layer has a thickness enough to protect the panel.

The following table lists the experimental results of sheet resistance and transmittance of the reduction layer according to an embodiment of the present invention.

| Sheet Resistance [Ω/m²] | Transmittance [%] |
|---|---|
| 20.00 | 92 |
| 12.00 | 91 |
| 6.10 | 90 |
| 4.00 | 88 |
| 1.80 | 85 |
| 1.00 | 75 |
| 0.80 | 67 |
| 0.70 | 63 |
| 0.65 | 60 |
| 0.60 | 57 |
| 0.56 | 54 |
| 0.50 | 51 |
| 0.47 | 48 |
| 0.43 | 45 |
| 0.40 | 42 |
| 0.36 | 39 |
| 0.33 | 35 |
| 0.31 | 33 |
| 0.28 | 30 |
| 0.26 | 27 |

The above table lists average values of an experiment when the thickness T of the reduction layer 15 ranges from 10 to 200 nm. It would be preferred that the highest sheet resistance of the reduction layer 15, which is required to shield EMI or NIR, be 4 Ω/m², and the lowest transmittance of the reduction layer 15, which is required to transmit light emitted from the inside of the panel, be 35 %.

As the transmittance of the reduction layer 15 increases, a luminance ratio of the panel increases. However, if the transmittance exceeds 88 %, the sheet resistance of the reduction layer 15 exceeds 4 Ω/m², resulting in making it impossible to sufficiently accomplish EMI and NIR-shielding. As the sheet resistance 15 of the reduction layer 15 decreases, the EMI- and NIR-shielding functions of the reduction layer 15 are improved. However, if the sheet resistance exceeds 0.33 Ω/m², the transmittance of the reduction layer 15 does not exceed 35 %, making it impossible to sufficiently secure the transmittance of the reduction layer 15. Accordingly, it is preferred that the sheet resistance of the reduction layer 15 be 4 Ω/m² or more, and the transmittance of the reduction layer 15 be 35 % or more. It would be more preferable that the reduction layer be formed in consideration of both the sheet resistance and transmittance.

The reason why the sheet resistance of the reduction layer 15 is set to 4 Ω/m² or less is that as the reduction layer 15 has an adequate thickness T, EMI generated from the inside of the plasma display panel can be properly shielded, and current, which is formed in the reduction layer due to EMI, can be easily drained into the ground. It can further improve the EMI-shielding effect and the NIR-shielding effect.

The reason why the transmittance of the reduction layer 15 is set to 35 % or more is that as the reduction layer 15 has an adequate thickness T, the luminance of the plasma display panel can be properly maintained and a better bright and dark room contrast ratio can be maintained.

FIG. 2 is a perspective view illustrating a first embodiment of a reduction layer of the plasma display panel according to the present invention.

Referring to FIG. 2, the reduction layer 15 having conductive materials 15a and 15b are directly formed on the front surface of the front substrate 10.

The conductive materials can be formed from one of ITO, IZO, IZTO, silver (Ag), aluminum (Al), copper (Cu) and Zinc (Zn).

As the reduction layer 15 comprising the conductive materials 15a and 15b is directly formed on the front surface of the front substrate 10, a Moire phenomenon or a double image phenomenon in which an image looks overlapped due to a difference in the refractive index and reflectance can be improved. Accordingly, a sharper image can be implemented.

The reduction layer 15 directly formed on the front surface of the front substrate 10 may comprise one layer or a plurality of layers. In the case where the reduction layer 15 comprises one layer, it can be formed using a conductive material, such as silver (Ag), aluminum (Al), copper (Cu) or Zinc (Zn).

Further, in the case where the reduction layer 15 comprises several layers, it can be formed by alternatively laminating a transparent conductive material, for example, a metal material such as ITO, IZO and IZTO, and one of silver (Ag), aluminum (Al), copper (Cu) and Zinc (Zn), or can be formed by laminating only one of the above metal materials.

The reduction layer 15 as illustrated in FIG. 2 can be formed by coating the conductive material on the front substrate 10 at lest once. In the case where the reduction layer 15 is formed by coating the conductive material several times, respective layers can have the same thickness.

The reduction layer 15 formed as described above can minimize a difference in the refractive index and the reflectance depending on each layer, and can therefore improve the Moire phenomenon or the double image phenomenon. The reduction layer 15 can prevent malfunction, which may occur since the wavelength of the plasma display panel is very close to that of a remote controller of electric home appliances when the plasma display panel is driven, and can also shield NIR induced from an inert gas, such as Ne and Xe.

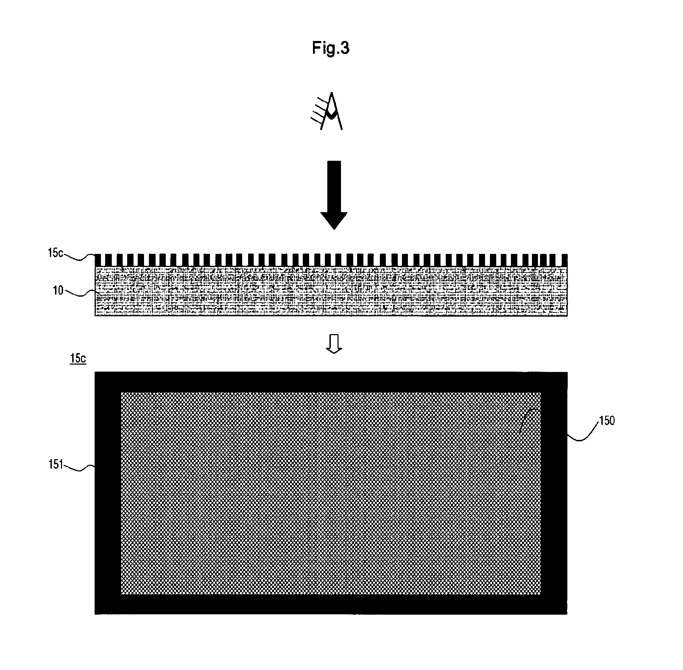

FIG. 3 is a perspective view illustrating a second embodiment of a reduction layer of the plasma display panel according to the present invention. There are shown, in FIG. 3, cross-sectional and front views of the plasma display panel.

As illustrated in FIG. 3, a reduction layer 15c of the present invention can be formed from copper (Cu) having a high conductivity in a lattice fashion.

The reduction layer 15c can have one layer formed by printing copper (Cu) directly on the front surface of the front substrate 1 in a lattice form. At this time, a metal material having a high conductivity, such as aluminum (Al), silver (Ag), chrome (Cr) or Zinc (Zn), can also be used instead of copper (Cu).

The structure of the reduction layer 15c according to a second embodiment of the present invention is formed in the lattice form, as described above, and therefore can secure an adequate transmittance. That is, in the case where the reduction layer is directly formed on the front surface of the front substrate 10 by using a metal material having high obscurity, such as copper (Cu), the luminance of the plasma display panel can be maintained and bright and dark room contrast can be secured since a structure having holes, such as the lattice form, is used.

The reduction layer 15c includes a mesh unit 150 formed in a lattice form in order to increase transmittance in a valid region of the panel, that is, a portion in which an image is actually displayed, and a ground unit 151 formed in an invalid region of the panel so as to increase the ground force of the reduction layer 15c.

The ground unit 151 can be formed only on one side of the invalid region or only on both sides of the invalid region. Alternatively, the ground unit 151 can be formed only at a portion of one side or both sides of the invalid region. Alternatively, the ground unit 151 can be formed only at the corners of the reduction layer.

Copper (Cu) constituting the reduction layer 15c is advantageous in that it can greatly shield EMI output from the inside of the panel, but is disadvantageous in that it does not shield NIR induced from an inert gas implanted into the plasma display panel. Due to this, the film filter or the glass filter including a NIR-shielding layer may be further formed on the reduction layer 15c.

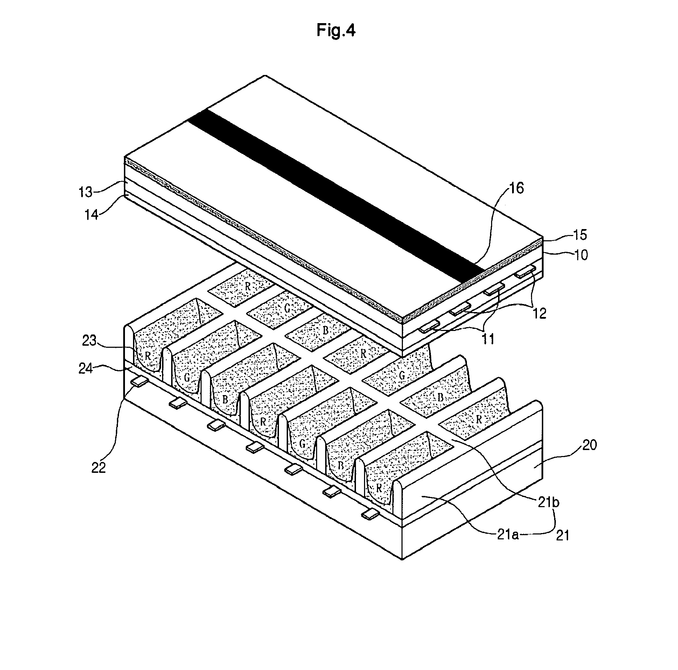

FIG. 4 is a perspective view illustrating a third embodiment of a reduction layer of the plasma display panel according to the present invention.

Referring to FIG. 4, in the third embodiment of the reduction layer of the plasma display panel according to the present invention, the reduction layer 15 formed from a conductive material is directly formed on the front surface of the front substrate 10, and a black material 16 is directly formed on the reduction layer 15 in a stripe form.

Meanwhile, it has been shown in FIG. 4 that the black material 16 is directly formed on the reduction layer 15. However, the black material 16 can be directly formed on the front surface of the front substrate 10 and the reduction layer 15 can be formed on the black material 16. Alternatively, only the black material 16 can be directly formed on the front surface of the front substrate 10, and another reduction layer can be formed on the black material 16.

The plasma display panel in which the black material is formed on the front substrate as described above can decrease the reflection of externally incident light to the greatest extent possible, and therefore can improve bright and dark room contrast. The black material 16 is preferably formed not to cover the discharge cells in order to maintain the luminance of the panel. In other words, the black material 16 is preferably overlapped with the barrier ribs 21. Further, the black material 16 can be formed on the longitudinal barrier ribs 21a as well as the traverse barrier ribs 21b, as illustrated in FIG. 4.

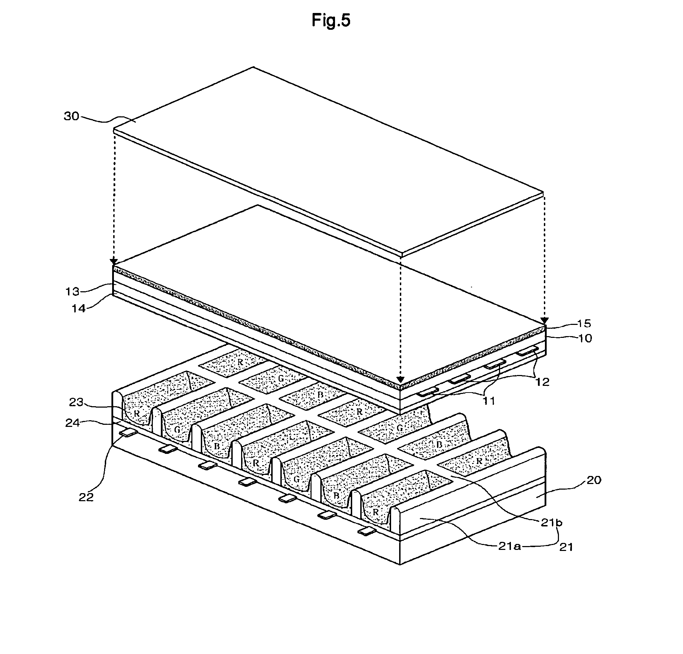

FIG. 5 is a view illustrating a second embodiment of the construction of a plasma display panel according to the present invention.

Referring to FIG. 5, the plasma display panel according to a second embodiment of the present invention includes a reduction layer 15 directly formed on a front surface of a front substrate 10, and a filter 30 formed on the reduction layer 15.

The filter 30 may comprise a film filter adhered closely to the reduction layer 15 or a glass filter spaced apart from the reduction layer 15 at a specific distance.

The film filter or the glass filter formed on the reduction layer 15 as described above may comprise at least one of an anti-reflection layer for reducing the reflection of external light, a color control layer for color adjustment and color correction, and an adhesive layer. The film filter or the glass filter may further comprise a NIR-shield layer and an external light-shielding layer.

The anti-reflection layer has prominences and depressions formed on the external surface of the filter 30, enabling sharper images by shielding ultraviolet rays and decreasing external reflected light.

The NIR-shield layer serves to shield NIR radiated from the panel so that signals transferred using infrared rays, such as a remote controller, can be normally transferred.

In general, an external light source exists over the head of a user indoor or outdoor. The external light-shielding layer functions to effectively shield the external light, thus making darker a black image of the panel darker.

The color control layer functions to increase the color purity of an image and control a tone of an image to be suitable for the image.

An adhesive layer is formed between the respective layers included in the filter 16. The respective layers and the filter 30 are firmly installed at the front of the reduction layer 15.

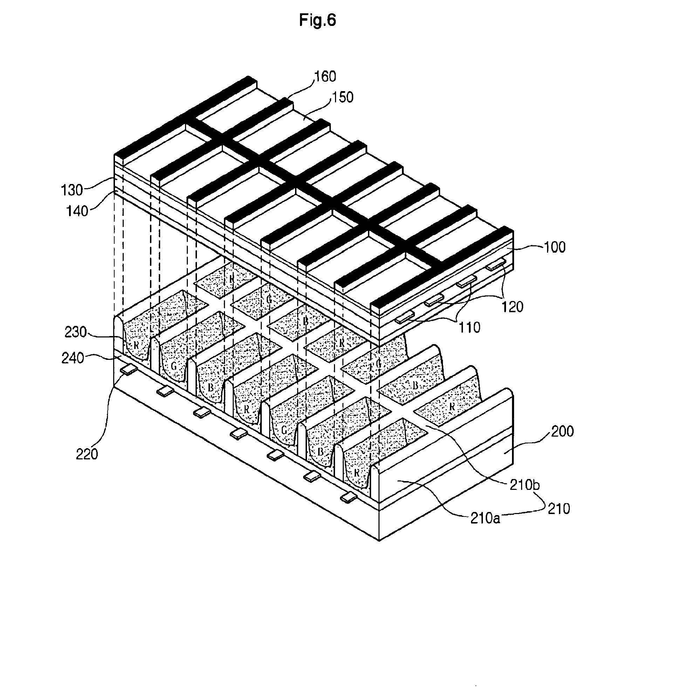

FIG. 6 is a perspective view illustrating a fourth embodiment of a reduction layer of the plasma display panel according to the present invention.

Referring to FIG. 6, a plasma display panel according to the present invention includes a front substrate 100 in which scan electrodes 110 and sustain electrodes 120 parallel to each other are formed, and a rear substrate 200 in which address electrodes 220 crossing the scan electrodes 110 and the sustain electrodes 120 are formed. The front substrate 100 and the rear substrate 200 are coalesced together. Hereafter, the construction of the plasma display panel shown in FIG. 6, which is the same as that of FIG. 1, will not be described in order to avoid redundancy.

Referring to FIG. 6, the plasma display panel of the present invention includes a first reduction layer 150 directly formed on a front surface of the front substrate 100 and formed from a conductive material, and a second reduction layer 160 formed on the first reduction layer 150 and formed from a black material.

The first reduction layer 150 can be formed using one of ITO, IZO, IZTO and silver (Ag), which can adequately secure transmittance and has a good conductivity. In this case, the EMI-shielding and NIR-shielding functions can be improved.

The first reduction layer 150 can be formed to a thickness T of 10 to 250 nm in consideration of the efficiency of the functions due to electrical characteristics and the transmittance of light. When the thickness of the first reduction layer 150 is 10 to 200 nm or less, adequate sheet resistance and transmittance can be obtained. In this case, the first reduction layer 150 directly formed on the front surface of the front substrate 100 can have sheet resistance of 4 Ω/m² or less and improved transmittance of 35 % or more.

The reason why the sheet resistance of the first reduction layer 150 is set to 4 Ω/m² or less is that as the first reduction layer 150 has an adequate thickness T, EMI output from the inside of the plasma display panel can be properly shielded, and current formed in the reduction layer due to EMI can be easily drained into the ground. It is therefore possible to effectively improve the EMI-shielding effect and the NIR-shielding effect.

The reason why the transmittance of the first reduction layer 150 is set to 35 % or more is that as the first reduction layer 150 has an adequate thickness T, the luminance of the plasma display panel can be properly maintained, and a better bright and dark room contrast ratio can be maintained.

The reduction layer 150 directly formed on the front surface of the front substrate 100 may comprise one layer or a plurality of layers. In the case where the reduction layer 150 comprises one layer, it can be formed using a conductive material, such as silver (Ag), aluminum (Al), copper (Cu) or Zinc (Zn).

Further, in the case where the reduction layer 150 comprises several layers, it can be formed by alternatively laminating a transparent conductive material, for example, a metal material such as ITO, IZO and IZTO, and one of silver (Ag), aluminum (Al), copper (Cu) and Zinc (Zn), or can be formed by laminating only one of the above metal materials.

The reduction layer 150 can be formed by coating the conductive material on the front substrate 100 at lest once. In the case where the reduction layer 150 is formed by coating the conductive material several times, respective layers can have the same thickness.

The reduction layer 150 formed as described above can minimize a difference in the refractive index and the reflectance depending on each layer, and can therefore improve the Moire phenomenon or the double image phenomenon. The reduction layer 150 can prevent malfunction, which may occur since the wavelength of the plasma display panel is very close to that of a remote controller of electric home appliances when the plasma display panel is driven, and can also shield NIR induced from an inert gas, such as Ne and Xe.

The second reduction layer 160 formed from the black material is directly formed on the first reduction layer 150. The second reduction layer 160 can comprise the black material, and a conductive material, such as copper (Cu), silver (Ag), aluminum (Al), Zinc (Zn) and chrome (Cr). In this case, an effect of preventing the reflection of external light can be improved by means of the black material, and an EMI-shielding effect can be further improved by means of the conductive material.

The second reduction layer 160 can be formed in a lattice form and overlapped with longitudinal barrier ribs 210a and traverse barrier ribs 210b, as illustrated in FIG. 6. Alternatively, the second reduction layer 160 can be formed in a stripe form and overlapped with any one of the longitudinal barrier ribs 210a and the traverse barrier ribs 210b.

It is preferred that a width of the black material constituting the second reduction layer range from 10 to 30 . In this case, the panel can have a sufficient aperture ratio. Accordingly, a sharp image with a better luminance can be implemented, and sheet resistance of the panel due to a thickness can be lowered. Consequently, an electrical conductivity is increased and the EMI-shielding effect can be improved.

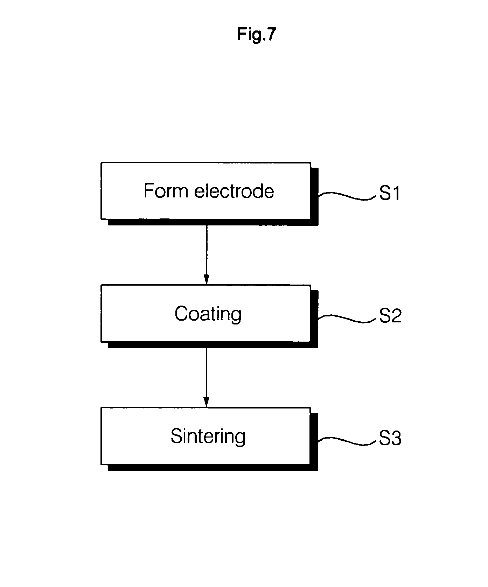

FIG. 7 is a flowchart illustrating an embodiment of a method of manufacturing a plasma display device according to the present invention.

Referring to FIG. 7, the plasma display panel of the present invention can be formed by an electrode formation step S1, a coating step S2 and a sintering step S30.

In the electrode formation step S1, scan electrodes and sustain electrodes are formed on a second surface of a front substrate by means of a photoresist method, a screen-printing method or the like.

In the coating step S2, a conductive material for forming a reduction layer is directly coated on a first surface of the front substrate. The method of coating the conductive material on the first surface of the front substrate as described above can include a method of coating a paste type conductive material through a sprayer by using one of a spin method, a sputtering method and a spray method.

The methods rarely generate bubbles when forming the reduction layer, and can significantly improve the uniformity of the reduction layer.

The spin method is advantageous in that it can naturally improve the uniformity of the reduction layer. The spin method is also advantageous in that it can greatly decrease the error rate unlike a conventional filter in terms of a process and can significantly enhance the process yield.

In particular, the spray method is advantageous in that it can control the thickness of a layer since a coating amount of the conductive material can be freely controlled.

In the sputtering method, a test sample, such as silver (Ag) or ITO, is set in a sputtering apparatus having a vacuum state, and the front substrate is set opposite to the test sample. In this state, if argon (Ar) gas is injected and voltage is applied, the argon (Ar) gas becomes a plasma state where the argon (Ar) gas is decomposed into argon (Ar) ions and electrons. The argon (Ar) ions collide against the silver (Ag) or ITO test sample, so that atoms of silver (Ag) or ITO jump up and are directly attached to the second surface of the front substrate, thus forming the reduction layer. In order for the conductive material, such as silver (Ag) or ITO, to have both the EMI-shielding effect and the NIR-shielding effect, the sputtering process can be performed several times in order to form a reduction layer having a plurality of layers.

After the conductive material is coated, a process of directly printing a black material and a process of drying the printed black material may be added.

The printing process can employ a thick film printing method, a direct patterning method or the like. In the printing process, a paste of the black material is coated on the front substrate in a stripe or lattice form using a mask.

The black material coated in the dry process is dried.

In the sintering step S3, the coated conductive material is sintered so that the conductive material is properly coupled and hardened to the front surface of the plasma display panel.

The sintering method may comprise thermal sintering, ultraviolet sintering, laser sintering and so on.

The thermal sintering method is performed on the whole plasma display panel in a thermal sintering furnace. The laser sintering method is suitable for locally sintering a portion to be sintered. The ultraviolet sintering method is performed on a portion on which ultraviolet rays have an effect through radiant heat by using an apparatus that emits ultraviolet rays, and is therefore suitable for sintering the surface of the plasma display panel. Accordingly, it is more preferred that the ultraviolet sintering method be used in the sintering step S3 of the reduction layer of the present invention.

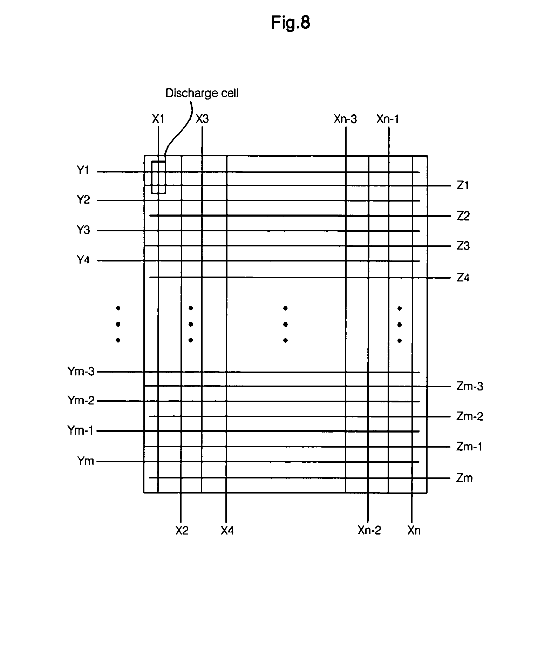

FIG. 8 is a view illustrating the arrangement of electrodes of the plasma display panel.

As illustrate din FIG. 8, a plurality of discharge cells constituting a plasma display panel are preferably located at the intersections of scan electrode lines Y1 to Ym and sustain electrode lines Z1 to Zm, and address electrode lines X1 to Xn, respectively, in matrix form. The scan electrode lines Y1 to Ym are sequentially driven, and the sustain electrode lines Z1 to Zm are commonly driven. The address electrode lines X1 to Xn are driven with them being divided into odd-numbered lines and even-numbered lines.

The electrode arrangement shown in FIG. 8 is an embodiment of an electrode arrangement of the plasma display panel according to the present invention, and therefore the present invention is not limited to the electrode arrangement and driving method of the plasma display panel illustrated in FIG. 3. For example, a dual scan or double scan method in which every two of the scan electrode lines Y1 to Ym are driven at the same time is possible.

In this case, the dual scan method is a method of, assuming that the plasma display panel is divided into two regions, that is, an upper region and a lower region, driving one scan electrode line belonging to the upper region and one scan electrode line belonging to the lower region at the same time. The double scan method is a method of driving two scan electrode lines that are consecutive to each other at the same time

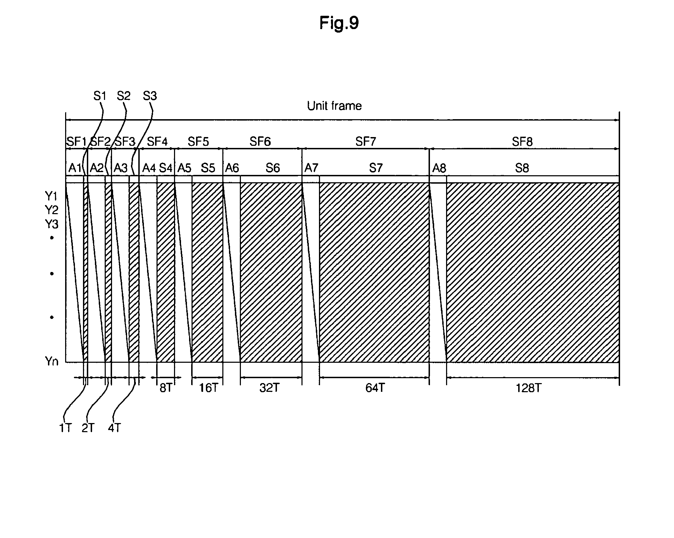

FIG. 9 is a view illustrating an embodiment of a method in which one frame of an image of the plasma display panel is driven with it being time-divided into a plurality of subfields.

Referring to FIG. 9, a unit frame can be driven with it being time-divided into eight subfields SF1, ...., SF8 in order to represent gray levels of an image. Each of the subfields SF1, ..., SF8 is divided into a reset period (not shown), address periods A1, ..., A8, and sustain periods S1, ..., S8.

In each of the address periods A1, ..., A8, a data signal is applied to the address electrodes X, and scan pulse corresponding to the data signals are sequentially applied to the scan electrodes Y. In each of the sustain periods S1, ..., S8, a sustain pulse is alternately applied to the scan electrodes Y and the sustain electrodes Z, so that a sustain discharge is generated in discharge cells selected in the address periods A1, ..., A8.

The luminance of the plasma display panel is proportional to the number of sustain discharges within the sustain periods S1, ..., S8, which is occupied in a unit frame. In the case where one frame forming one image is represented with eight subfields and 256 gray levels, the respective subfields are allocated with different numbers of sustain pulses at the ratio of 1, 2, 4, 8, 16, 32, 64 and 128. Alternatively, in order to obtain the luminance of 133 gray levels, a sustain discharge can be performed by addressing cells during a subfield 1 period, a subfield 3 period and a subfield 8 period.

Meanwhile, the number of sustain discharges, which is allocated to each subfield, can be varied depending on weights of subfields in accordance with an Automatic Power Control (APC) step. That is, an example in which one frame is divided into eight subfields has been described with reference to FIG. 9. However, the present invention is not limited to the above example, but the number of subfields forming one frame can be changed in various ways depending on design specifications. For example, the plasma display panel can be driven with one frame being divided into eight subfields or more or eight subfields or less, such as 12 or 16 subfields.

The number of sustain discharges allocated to each subfield can be changed in various ways in consideration of a gamma characteristic or panel characteristics. For instance, a gray level allocated to the subfield 4 can be lowered from 8 to 6, and a gray level allocated to the subfield 6 can be raised from 32 to 34.

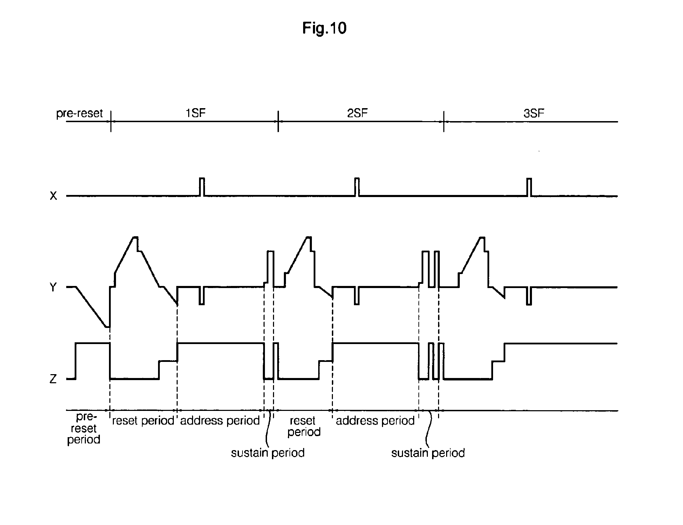

FIG. 10 shows a waveform illustrating an embodiment of driving signals for driving the plasma display panel with respect to divided subfields.

Referring to FIG. 10, a subfield SF is divided into a reset period in which charges within discharge cells are reset, an address period in which discharge cells on which an image is displayed and discharge cells on which an image is not displayed are selected, and a sustain period in which a sustain discharge is generated in discharge cells which are selected in the address period and on which an image will be displayed, thus generating an image. The reset period is again divided into a setup period and a setdown period.

In the setup period, a setup signal that gradually rises is applied to the scan electrodes Y, so that a setup discharge is generated within the entire discharge cells. Accordingly, wall charges are accumulated on the discharge cells. In the setdown period, a setdown signal that gradually falls is applied to the scan electrodes Y, so that a weak erase discharge is generated within the entire discharge cells. Accordingly, wall charges of the extent that an address discharge can be generated stably uniformly remain within the discharge cells.

Further, a pre-reset period may exist anterior to the reset period. In the pre-reset period, sufficient formation of wall charges are assisted, and a positive voltage is applied to the sustain electrodes Z while a waveform in which a voltage value of the scan electrode Y gradually falls is applied prior to the reset period, thus generating a pre-reset discharge. It is preferred that the pre-reset period exist only in the first subfield SF1 considering driving margin.

In the address period, while a scan signal is sequentially applied to the scan electrodes Y, a positive data signal synchronized with the scan signal applied to the scan electrodes Y is applied to the address electrodes X. A voltage difference between the scan signal and the data signal and wall charges generated during the reset period are added to generate an address discharge within the discharge cells. Accordingly, wall charges for a sustain discharge are formed within discharge cells.

In the sustain period, a sustain signal is alternately applied to the scan electrodes Y and the sustain electrodes Z. A sustain discharge, that is, a display discharge is generated in discharge cells selected by the address discharge whenever the sustain signal is applied.

Meanwhile, the waveforms illustrated in FIG. 10 are embodiments of signals for driving the plasma display panel according to an embodiment of the present invention. The present invention is not limited to the waveforms illustrated in FIG. 10. For example, the reset period may be omitted from at least one of a plurality of subfields constituting one frame, the reset period may exist only in the first subfield, and the pre-reset period may be omitted.

The polarity and voltage level of each of the driving signals illustrated in FIG. 10 can be varied, if appropriate. After the sustain discharge is completed, an erase signal for erasing wall charges can be applied to the sustain electrodes Z. Furthermore, single sustain driving in which the sustain signal is applied to only the scan electrodes Y or the sustain electrodes Z to generate a sustain discharge is possible.

While the invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A plasma display device including a front substrate, and a rear substrate opposite to the front substrate and having a plurality of barrier ribs for physically dividing discharge cells formed therein, the plasma display device comprising:
a first electrode and a second electrode formed on a first surface of the front substrate; and
a reduction layer directly formed on a second surface of the front substrate.

2. The plasma display device of claim 1, wherein the reduction layer comprises at least one layer formed from a conductive material.

3. The plasma display device of claim 2, wherein the conductive material includes at least one of ITO, IZO, IZTO and silver (Ag).

4. The plasma display device of claim 1, wherein the reduction layer is formed from a metal material of a lattice form.

5. The plasma display device of claim 1, wherein the reduction layer includes a black layer directly formed on the second surface, or two or more layers including the black layer.

6. The plasma display device of claim 1, wherein the reduction layer has a thickness of 10 to 250 nm.

7. The plasma display device of claim 1, wherein the reduction layer has a thickness of 10 to 200 nm.

8. The plasma display device of claim 1, wherein the reduction layer has sheet resistance of 4 Ω/m² or less and transmittance of 35 % or more.

9. The plasma display device of claim 1, wherein a film filter closely adhered to the reduction layer is formed over the reduction layer, or a glass filter spaced apart from the reduction layer at a specific distance is formed over the reduction layer.

10. The plasma display device of claim 1, wherein one of a film filter and a glass filter formed over the reduction layer includes at least one of an anti-reflection layer for decreasing reflection of external light, a color control layer for color adjustment and color correction, and an adhesive layer.
